# EUROPÄISCHE PATENTSCHRIFT

(11) **EP 1 347 358 B1**
(45) Veröffentlichungstag und Bekanntmachung des Hinweises auf die Patenterteilung: **06.04.2011**
(21) Anmeldenummer: 03004165.1
(22) Anmeldetag: 26.02.2003
(51) Int. Cl.: G06F 1/18

(54) **Anordnung zur Kontaktierung eines Einschubwinkels**
Device for connecting a bracket in a slot
Dispositif pour assurer le contact entre une plaque de fixation et une rainure

(30) Priorität: 12.03.2002 DE 10210710
(43) Veröffentlichungstag der Anmeldung: 24.09.2003
(73) Patentinhaber: Fujitsu Technology Solutions Intellectual Property GmbH, 80807 München (DE)
(72) Erfinder: Neukam, Wilhelm, 86399 Bobingen (DE)
(74) Vertreter: Epping - Hermann - Fischer

(56) Entgegenhaltungen:
- EP-A- 1 091 279
- DE-A1- 10 008 282
- US-A- 5 929 376
- US-B1- 6 349 042

## Beschreibung

Die Erfindung betrifft eine Anordnung zur Kontaktierung eines Slotwinkels an einem Slotfeld in einem Computergehäuse.

Nach dem Stand der Technik wird eine derartige Kontaktierung durch eine Feder, die sich zwischen dem Computergehäuse und dem Slotwinkel befindet, bewerkstelligt.

Prozessoren und Speicher der neuen Generation arbeiten mit immer niedrigeren Schaltspannungen, wodurch die Bauelemente immer empfindlicher gegenüber Störspannungen reagieren. Eine EMV-Kontaktierung nach dem Stand der Technik ist nicht mehr ausreichend. Es ist zu erwarten, daß zukünftige Generationen von Computerbauelementen mit noch niedrigeren Schaltspannungen betrieben werden, wodurch die Anfälligkeit für Störspannungen erhöht wird und deswegen eine bessere Kontaktierung unbedingt erforderlich sein wird. Weiterhin steigen durch zunehmend höheren Taktfrequenzen, die bei Computern eingesetzt werden, die Ansprüche an die EMV-Dichtigkeit des Computergehäuses.

Anordnungen zur Kontaktierung von Slotwinkeln sind zum Beispiel aus den Druckschriften DE 100 08 282 A1, US 5 929 376 A, US 6 018 464 und US 6 349 042 B1 bekannt.

In der DE 100 08 282 A1 wird eine am Computergehäuse befestigte Kontaktfeder beschrieben, die einen eingesteckten Slotwinkel seitlich kontaktiert. Durch diese Anordnung kann zwar ein guter Kontakt zwischen dem Slotwinkel und dem Computergehäuse erreicht werden, die geforderte EMV-Dichtigkeit des Computergehäuses ist jedoch nicht gewährleistet.

Bei der in der Druckschrift US 5 929 376 A beschriebenen Anordnungen sind Federstreifen mit Kontaktfedern an der inneren Seite eines Slotfeldes mittels eines Steges befestigt. Die jeweils beidseitig neben den Stegen angeordneten Kontaktfedern kontaktieren die Slotwinkel an ihrer Stirnfläche parallel zum Slotfeld. Auf diese Weise lassen sich Anforderungen an die EMV-Dichtigkeit leichter erreichen, die Federkraft der Kontaktfedern kann jedoch zu einer Durchbiegung des Slotwinkels führen und übt zudem über die Anschlüsse einer an dem Slotwinkel befestigten Einsteckkarte unerwünschte Kräfte auf die Hauptplatine des Computers aus. Die Stege dienen neben der Befestigung der Federstreifen einer seitlichen Führung des Slotwinkels. Die seitliche Führung verringert die Gefahr von Kurzschlüssen, wenn eine Einsteckkarte im Betrieb des Computers (Hotplug) eingesetzt und dabei verkantet wird.

Die Druckschrift US 6 018 464 offenbart eine Anordnung umfassend eine Zusatzkarte mit einem Slotwinkel und ein von einem Gehäusechassis hervorstehendes Abschirmteil. Das Abschirmteil dient der Führung des Slotwinkels und schirmt elektromagnetische Störstrahlung selbst dann ab, wenn der Slotwinkel durchgebogen ist.

Die Druckschrift US 6 349 042 B1 offenbart eine Anordnung, bei der abgewinkelte Federelemente jeweils beidseitig der Öffnungen eines Slotfeldes verlaufen. Eingesetzte Slotwinkel erfahren über die Federelemente sowohl Kontaktierung, als auch eine seitliche Führung. Die Federelemente sind im wesentlichen über die gesamte Höhe des Slotwinkels ausgeführt, woraus eine gute EMV-Dichtigkeit resultiert, die durch den zusätzlichen Einsatz einer EMV-Dichtung noch erhöht werden kann. Die Anordnung der der Federelemente führt jedoch ebenfalls zu unerwünschten Kräften auf die Anschlüsse einer Einsteckkarte und über diese auf die Hauptplatine des Computers.

Der Erfindung liegt die Aufgabe zugrunde, eine Anordnung zur Kontaktierung eines Slotwinkels an einem Slotfeld zu schaffen, die eine optimale Kontaktierung und EMV-Dichtigkeit zwischen Slotwinkel und Computergehäuse gewährleistet und verhindert, daß auf den Slotwinkel ausgeübte Kräfte auf eine an dem Slotwinkel befestigte Einsteckkarte übertragen werden.

Die Aufgabe wird erfindungsgemäß durch eine Anordnung zur Kontaktierung eines Slotwinkels an einem Slotfeld in einem Computergehäuse gelöst, wobei an dem Slotfeld eine Führungsschiene zum Einschieben des Slotwinkels vorgesehen ist. Die Anordnung zeichnet sich dadurch aus, daß die Führungsschiene einen zum Slotfeld senkrecht stehenden Träger und eine zum Slotfeld parallele Blende aufweist, die zusammen mit dem Slotfeld eine u-förmige Führung für den Slotwinkel bilden. Dabei ist in der u-förmigen Führungsschiene eine komprimierbare EMV-Dichtung angeordnet.

Durch eine derartige Anordnung wird eine gleichmäßige Kontaktierung des gesamten Slotwinkels an dem Computergehäuse gewährleistet und gleichzeitig eine Führung des Slotwinkels parallel und senkrecht zum Slotfeld erreicht. In einer Richtung senkrecht und parallel auf den Slotwinkel ausgeübte Kräfte, hervorgerufen beispielsweise während des Einsteckens des Slotwinkels oder durch vorgesehene Kontakt- oder Dichtmittel, werden von der Führungsschiene aufgenommen. Eine Steigerung der EMV-Schirmung wird durch die Anordnung der EMV-Dichtung in den Führungsschienen erzielt.

In einer vorteilhaften Weiterbildung sind pro Slotwinkel zwei Führungsschienen ausgebildet.

Eine vorteilhafte Ausführungsform sieht vor, daß die Dichtung aus einem komprimierbaren Material besteht.

Bei der komprimierbaren Dichtung ist günstigerweise die Dicke der nicht komprimierten Dichtung zusammen mit der Dicke des Slotwinkels größer als die lichte Breite der Führungsschiene.

Wenn der Slotwinkel eingeschoben wird, wird die Dichtung zusammengepreßt und somit die Abschirmung verstärkt. Gleichzeitig wirkt eine Kraft auf den Slotwinkel, die diesen festlegt.

Nachfolgend wird die Erfindung anhand eines in den Zeichnungen dargestellten Ausführungsbeispiels erläutert.

In den Zeichnungen zeigen:
- Figur 1: eine Schrägansicht eines Slotfeldes mit eingesteckter PCI-Steckkarte und Slotwinkel,
- Figur 2: eine Draufsicht des Slotfeldes mit eingesteckter PCI-Karte und Slotwinkel,
- Figur 3: einen Querschnitt durch eine Führungsschiene an einem Slotfeld mit eingesetzter EMV-Dichtung,
- Figur 4: einen Querschnitt durch eine Führungsschiene am Slotfeld mit eingesetzter EMV-Dichtung und einge- schobenem Slotwinkel.

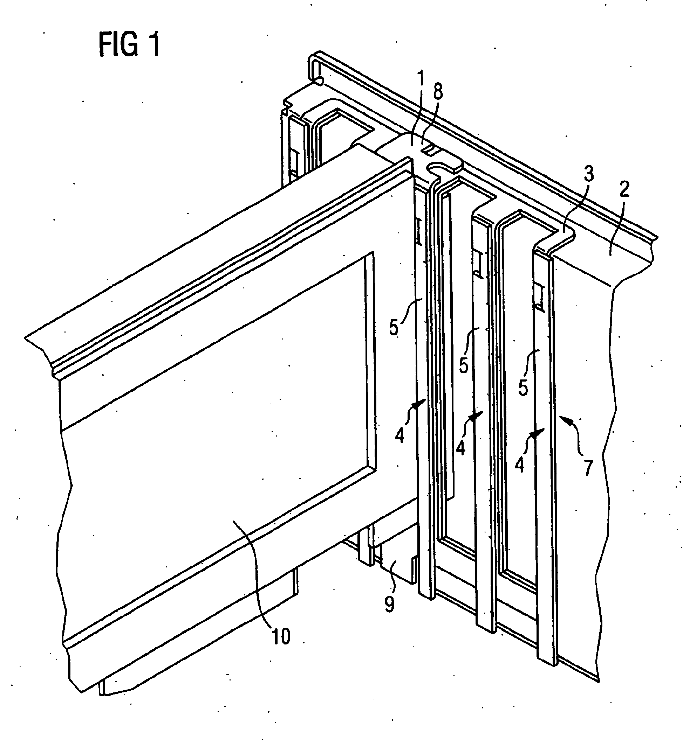

Figur 1 zeigt ein Slotfeld 7 in einem Computergehäuse 2 und eine PCI-Steckkarte 10 die an einem Slotwinkel 1 angebracht ist.

Der Slotwinkel 1 weist einen senkrechten Abschnitt 9 sowie einen waagrechten Abschnitt 8 auf.

Mit seinem senkrechten Abschnitt 9 wird der Slotwinkel 1 in zwei Führungsschienen 4 eingeschoben , welche aus einer Blende 5 und einem in dieser Figur verdeckten Träger 6 bestehen. Durch den Träger 6 ist die Blende 5 am Slotfeld 7 befestigt.

An der Auflagefläche ist sowohl für den senkrechten Abschnitt 9 des Slotwinkels 1 als auch für den waagrechten Abschnitt 8 eine EMV-Dichtung 3 angeordnet.

Die Führungsschienen 4 sind nur für die senkrechten Abschnitte 9 des Slotwinkels 1 ausgebildet.

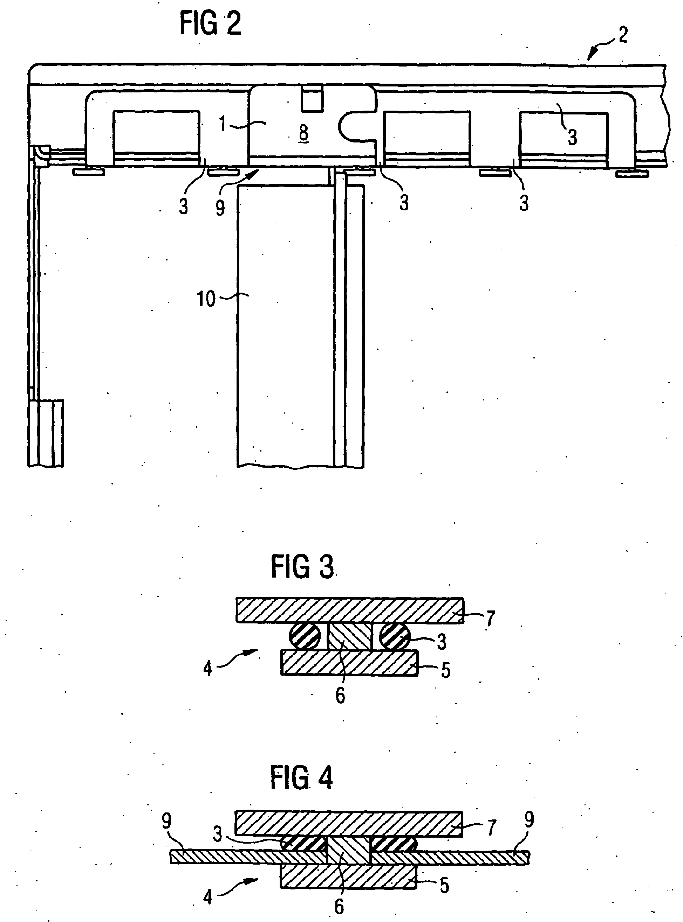

Wie in Figur 2 dargestellt ist, befindet sich die EMV-Dichtung 3 auch in den Führungsschienen 4.

Die Figuren 3 und 4 zeigen, welcher Effekt erzielt wird, wenn in die Führungsschiene 4 ein Slotwinkel 1 mit seinem senkrechten Abschnitt 9 eingeschoben wird.

Fiur 3 zeigt einen Querschnitt durch den senkrechten Abschnitt des Slotfeldes 7, den Träger 6 und die Blende 5, durch welche eine Führungsschiene 4 gebildet wird. In der Führungsschiene ist eine EMV-Dichtung 3 im nicht komprimierten Zustand angeordnet.

Figur 4 zeigt die Ansicht gemäß Figur 3, wobei hier zwei Slotwinkel 1 rechts und links in die Führungsschiene 4 eingeschoben sind. Von den Slotwinkeln 1 sind nur die senkrechten Abschnitte 9 dargestellt.

Durch die senkrechten Abschnitte 9 der Slotwinkel 1 werden die EMV-Dichtungen 3 derart komprimiert, daß die Abschirmung gegen Störspannungen maximal wird und außerdem der Slotwinkel 1 gegen die Blende 5 gedrückt wird.

Die Erfindung ist nicht auf das dargestellte Ausführungsbeispiel beschränkt. Die EMV-Dichtung 3 kann auch stirnseitig zwischen Slotwinkel und Führungsschiene, zwischen Slotwinkel und Blende 5 oder U-förmig in der Führungsschiene ausgebildet sein.

Als EMV-Dichtung 3 kann Metallgeflecht (Gasket) oder auch Federblech verwendet werden.

### Bezugszeichenliste

- 1: Slotwinkel
- 2: Computergehäuse
- 3: EMV-Dichtung
- 4: Führungsschiene
- 5: Blende
- 6: Träger
- 7: Slotfeld
- 8: waagrechter Abschnitt
- 9: senkrechter Abschnitt
- 10: PCI-Steckkarte

## Patentansprüche

1. Anordnung zur Kontaktierung eines Slotwinkels (1) an einem Slotfeld (7) in einem Computergehäuse (2), wobei an dem Slotfeld (7) eine Führungsschiene (4) zum Einschieben des Slotwinkels (1) vorgesehen ist,
**dadurch gekennzeichnet, dass**
die Führungsschiene (4) einen zum Slotfeld (7) senkrecht stehenden Träger (6) und eine zum Slotfeld (7) parallele Blende (5) aufweist, die zusammen mit dem Slotfeld (7) eine U-förmige Führung für den Slotwinkel (1) bilden, und in der U-förmigen Führungsschiene (4) eine komprimierbare EMV-Dichtung (3) angeordnet ist.

2. Anordnung nach Anspruch 1
**dadurch gekennzeichnet, dass** pro Slotwinkel (1) zwei Führungsschienen (4) ausgebildet sind.

3. Anordnung nach Anspruch 1 oder 2
**dadurch gekennzeichnet, dass** ein Federblech als EMV-Dichtung (3) verwendet wird.

4. Anordnung nach Anspruch 1 oder 2
**dadurch gekennzeichnet, dass** die EMV-Dichtung (3) aus einem komprimierbaren Material besteht.

5. Anordnung nach Anspruch 1 bis 4
**dadurch gekennzeichnet, dass** die Dicke der nicht komprimierten EMV-Dichtung (3) zusammen mit der Dicke eines senkrechten Abschnittes (9) des Slotwinkels (1) grösser ist als die lichte Breite der Führungsschiene.

6. Anordnung nach Anspruch 1 bis 5
**dadurch gekennzeichnet, dass** bei eingeschobenem Slotwinkel (1) die EMV-Dichtung (3) zusammengepresst ist und mit der entstehenden Gegenkraft der Slotwinkel (1) festgelegt wird.

## Claims

1. Arrangement for making contact with a slot angle piece (1) on a slot panel (7) in a computer housing (2), with a guide rail (4) for inserting the slot angle piece (1) being provided on the slot panel (7), **characterized in that** the guide rail (4) has a carrier (6) which is perpendicular to the slot panel (7) and a panel (5) which is parallel to the slot panel (7), the carrier (6) and the panel (5) together with the slot panel (7) form a U shaped guide for the slot angle piece (1), and a compressible EMC seal (3) is arranged in the U shaped guide rail (4).

2. Arrangement according to Claim 1, **characterized in that** two guide rails (4) are formed per slot angle piece (1).

3. Arrangement according to Claim 1 or 2, **characterized in that** sheet steel is used as the EMC seal (3).

4. Arrangement according to Claim 1 or 2, **characterized in that** the EMC seal (3) is composed of a compressible material.

5. Arrangement according to Claims 1 to 4, **characterized in that** the thickness of the noncompressed EMC seal (3) together with the thickness of a perpendicular section (9) of the slot angle piece (1) is greater than the clear width of the guide rail.

6. Arrangement according to Claims 1 to 5, **characterized in that** when the slot angle piece (1) is inserted the EMC seal (3) is pressed together and is secured by means of the resulting opposing force of the slot angle pieces (1).

## Revendications

1. Dispositif pour assurer le contact entre un profilé à rainure (1) et une plaque de rainure (7) dans un boîtier d'ordinateur (2), dans lequel il et prévu sur la plaque de rainure (7) un rail de guidage (4) pour l'insertion du profilé à rainure (1), **caractérisé en ce que** le rail de guidage (4) présente un support (6) dressé perpendiculairement à la plaque de rainure (7) et un écran (5) parallèle à la plaque de rainure (7), qui forment conjointement avec la plaque de rainure (7) un guidage en forme de U pour le profilé à rainure (1), et un joint CEM compressible (3) est disposé dans le rail de guidage en forme de U (4).

2. Dispositif selon la revendication 1, **caractérisé en ce que** deux rails de guidage (4) sont formés par profilé à rainure (1).

3. Dispositif selon la revendication 1 ou 2, **caractérisé en ce que** l'on utilise une tôle élastique comme joint CEM (3).

4. Dispositif selon la revendication 1 ou 2, **caractérisé en ce que** le joint CEM (3) est composé d'un matériau compressible.

5. Dispositif selon les revendications 1 à 4, **caractérisé en ce que** l'épaisseur du joint CEM non compressible (3) ajoutée à l'épaisseur d'une partie verticale (9) du profilé à rainure (1) est plus grande que la largeur libre du rail de guidage.

6. Dispositif selon les revendications 1 à 5, **caractérisé en ce que**, lorsque le profilé à rainure (1) est inséré, le joint CEM (3) est comprimé et le profilé à rainure (1) est immobilisé par la force antagoniste créée.
